# EUROPEAN PATENT APPLICATION

(11) **EP 4 513 539 A1**
(43) Date of publication of application: **26.02.2025**
(21) Application number: 22938338.5
(22) Date of filing: 19.12.2022
(51) Int. Cl.: H01L 21/687

(54) **WAFER STAGE APPARATUS**

(30) Priority: 20.04.2022 CN 202210417221
(71) Applicant: Jiangsu Leuven Instruments Co., Ltd., Xuzhou, Jiangsu 221300 (CN)
(72) Inventor: SANG, Kang, Xuzhou, Jiangsu 221300 (CN); HU, Dongdong, Xuzhou, Jiangsu 221300 (CN); CHEN, Longbao, Xuzhou, Jiangsu 221300 (CN); LIU, Pengfei, Xuzhou, Jiangsu 221300 (CN); WANG, Chengyi, Xuzhou, Jiangsu 221300 (CN); CHENG, Shiran, Xuzhou, Jiangsu 221300 (CN); GUO, Song, Xuzhou, Jiangsu 221300 (CN); XU, Kaidong, Xuzhou, Jiangsu 221300 (CN)
(74) Representative: Eisenführ Speiser
(86) International application number: PCT/CN2022/139934
(87) International publication number: WO 2023/202120

(57) **Abstract**

A wafer stage apparatus, comprising: a rotating platform assembly, comprising a supporting platform and a crimping part, the supporting platform being used for supporting a wafer, and the crimping part being used for pressing the wafer; a magnetic fluid shaft, comprising an inner shaft and an outer shaft, a magnetic fluid being arranged between the inner shaft and the outer shaft, the inner shaft comprising an end part member and a cylindrical member, and the end part member and the cylindrical member enclosing to form an accommodating space; and a lifting assembly, comprising a main body portion and a lifting body, the main body portion being located in the accommodating space, the lifting body being slidably and hermetically assembled on the end part member, and the lifting body interacting with the crimping part. The described wafer stage apparatus can more fully utilize the internal space of the inner shaft, so as to improve the structural compactness and the level of integration of the equipment, and the space occupied by the wafer stage apparatus can be effectively reduced, facilitating mounting.

## Description

The present application claims the priority of the Chinese Patent Application No. 202210417221.3, titled "WAFER STAGE APPARATUS", filed on April 20, 2022 with the China National Intellectual Property Administration, which is incorporated herein by reference in its entirety.

### FIELD

The present application relates to the technical field of wafer manufacturing, and in particular to a wafer stage apparatus.

### BACKGROUND

Ion beam etching and ion beam deposition are two common wafer processing technologies. The ion beam etching is a purely physical process, in which ions with certain energy are used to bombard a material surface to make material atoms sputter, thus achieving a purpose of etching. The ion beam deposition is a vapor deposition method, in which an ion source is used to ionize the material to be deposited, and ions are emitted to a surface of wafer under an action of an electric field to deposit a film layer, with a purpose of changing the surface properties of the workpiece.

In the process, the ion source is usually in a fixed position, and then the processing position is adjusted by rotating the wafer. The whole machining process is in a vacuum environment. For this purpose, in the conventional technology, there is a stage apparatus for supporting the wafer, which provides a driving force to achieve the movement required for processing the wafer.

However, the existing stage apparatus generally has problems of large size and large space occupation.

### SUMMARY

An object of the present application is to provide a wafer stage apparatus, which has high compactness and can effectively reduce the occupied volume.

In order to solve the above technical problems, a wafer stage apparatus is provided according to the present application, including a rotating platform assembly, a hydromagnetic shaft and a lifting assembly. The rotating platform assembly includes a supporting platform and a clamping part. The supporting platform is used to support a wafer, and the clamping part is used to clamp the wafer. The hydromagnetic shaft includes an inner shaft and an outer shaft, and a magnetic fluid is provided between the inner shaft and the outer shaft. The inner shaft includes an end member and a cylindrical member which define an accommodating space. The lifting assembly includes a main body and a lifter. The main body is located in the accommodating space. The lifter is slidably and hermetically assembled on the end member, and the lifter interacts with the clamping part.

With the above solution, the inner shaft of the hydromagnetic shaft is bucket-shaped forming therein the accommodating space in which the main body of the lifting assembly for driving the clamping part to move relative to the supporting platform is located. In this way, the internal space of the inner shaft can be more fully utilized, so that the structural compactness and integration of the apparatus can be improved, effectively reducing the occupied space of the wafer stage apparatus and facilitating mounting.

Optionally, the main body includes a pneumatic cylinder and a lifting plate. The pneumatic cylinder is provided with a piston rod which is connected with the lifting plate, and the lifting plate is connected with several lifters.

Optionally, the main body further includes a bellows, two ends of which are respectively connected with the lifting plate and the end member, and which is mounted outside the lifter.

Optionally, the lifting assembly further includes a jacking pin, and the jacking pin is slidably and hermetically assembled to the end member.

Optionally, one lifter and one jacking pin share a bellows for sealing assembly.

Optionally, the main body includes a pneumatic cylinder and a lifting plate. The pneumatic cylinder is provided with a piston rod which is connected with the lifting plate. The jacking pin and the lifter are both mounted on the lifting plate, and an axial size of the jacking pin is smaller than that of the lifter.

Optionally, the hydromagnetic shaft is provided with a first cooling channel.

Optionally, a side of the end member facing the supporting body is provided with a groove. A sealing plate is further provided on the side of the end member facing the supporting body and covers an opening of the groove. The first cooling channel includes an internal space of the groove body.

Optionally, the wafer stage apparatus further includes a housing assembly and a driving assembly. The internal space of the housing assembly is communicated with atmospheric environment, and the housing assembly includes a supporting plate on which the outer shaft is hermetically assembled. At least part of the driving assembly is located in the housing assembly, and the driving assembly is in transmission connection with the inner shaft.

Optionally, the driving assembly includes a stator, a rotor and a mounting member. The rotor is in transmission connection with the inner shaft, and the mounting member is used for mounting the driving assembly.

Optionally, the mounting member is provided with a second cooling channel.

Optionally, the mounting member includes a first connecting portion and a second connecting portion which are connected with each other. The first connecting portion is connected with the outer shaft, and the second cooling channel is formed between the first connecting portion and the second connecting portion.

Optionally, the first connecting portion is provided with a first stop and the second connecting portion is provided with a second stop. The stator is positioned and assembled by the first stop and the second stop.

Optionally, the wafer stage apparatus further includes a rotating plate, and the rotor is connected to the inner shaft via the rotating plate.

Optionally, the wafer stage apparatus further includes a revolving shaft, and the revolving shaft is connected with the housing assembly.

Optionally, the supporting platform includes a heating platform portion and a cooling platform portion.

Optionally, a surface of the cooling platform portion facing the heating platform portion is provided with a third cooling channel. The wafer stage apparatus further includes a sealing portion, which is arranged between the cooling platform portion and the heating platform portion.

Optionally, the wafer stage apparatus further includes a back helium portion, and the back helium portion is located at a side of the supporting platform close to the wafer.

Optionally, the wafer stage apparatus further includes a rotating joint, which is connected with the end member.

Optionally, the wafer stage apparatus further includes a transition plate, and the rotating joint is connected to the end member via the transition plate.

### BRIEF DESCRIPTION OF THE DRAWINGS

FIG. 1 is a schematic structural view of a specific embodiment of a wafer stage apparatus provided according to the present application;
FIG. 2 is a schematic structural view of a hydromagnetic shaft shown in FIG. 1;
FIG. 3 is a schematic structural view of a lifting assembly shown in FIG. 1;
FIG. 4 is a schematic structural view of a supporting platform shown in FIG. 1;
FIG. 5 is a schematic structural view of a driving assembly shown in FIG. 1.

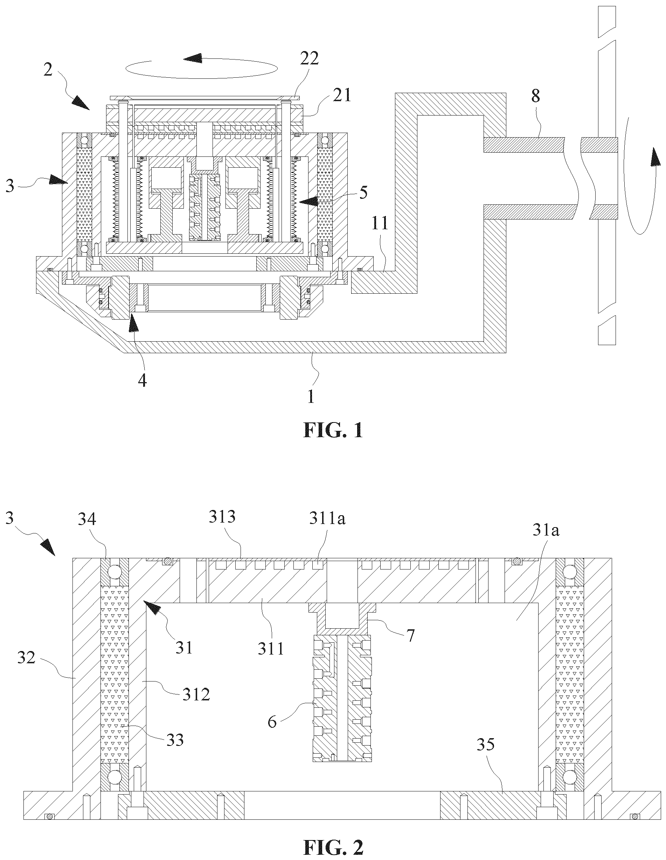

Description of the reference numerals in FIGS. 1 to 5:
1 housing assembly, 11 supporting plate;
2 rotating platform assembly, 21 supporting platform, 211 heating platform portion, 212 cooling platform portion, 212a third cooling channel, 212a-1 inlet, 212a-2 outlet, 213 sealing portion, 214 back helium portion, 22 clamping part;
3 hydromagnetic shaft, 31 inner shaft, 31a accommodating space, 311 end member, 311a first cooling channel, 312 cylindrical member, 313 sealing plate, 32 outer shaft, 33 magnetic fluid, 34 bearing, 35 rotating plate;
4 driving assembly, 41 stator, 42 rotor, 43 mounting member, 431 first connecting portion, 432 second connecting portion, 433 second cooling channel;
5 lifting assembly, 51 main body, 511 pneumatic cylinder, 511a piston rod, 512 lifting plate, 513 bellows, 52 lifter, 53 jacking pin;
6 rotating joint;
7 transition plate;
8 revolving shaft.

### DETAILED DESCRIPTION OF THE EMBODIMENTS

Hereinafter, in order to enable those skilled in the art to better understand the technical solutions of the present application, the present application will be described in further detail with reference to the accompanying drawings in conjunction with specific embodiments.

In the specification, the term "multiple" refers to a plural indefinite number or quantity, usually more than two. When the term "multiple" is used to indicate the number of certain components, it does not mean that these components are quantitatively related to each other.

Herein, the terms such as "first" and "second" are only intended to distinguish two or more structures or components that have identical or similar structure and/or functions, and do not indicate any special limitation on an order and/or importance.

Magnetic fluid, also known as magnetic liquid or ferrofluid, is a colloidal material composed of solid and liquid phases. The solid phase mainly refers to magnetic solid nanoparticles, and the liquid phase refers to the liquid that can carry the solid magnetic nanoparticles. The magnetic fluid has the fluidity, lubricity and sealing performance of liquid carriers, and also has the strong magnetism and other characteristics of solid nanoparticles.

Hydromagnetic sealing is to fix the magnetic fluid between an inner shaft and an outer shaft with permanent magnets. Since a gap between the inner shaft and the outer shaft is very small and its magnetic field strength is particularly large, it can bear a large thrust along a direction of an axis to achieve the sealing effect. The inner shaft, the outer shaft and the magnetic fluid provided therebetween can be collectively called the hydromagnetic shaft.

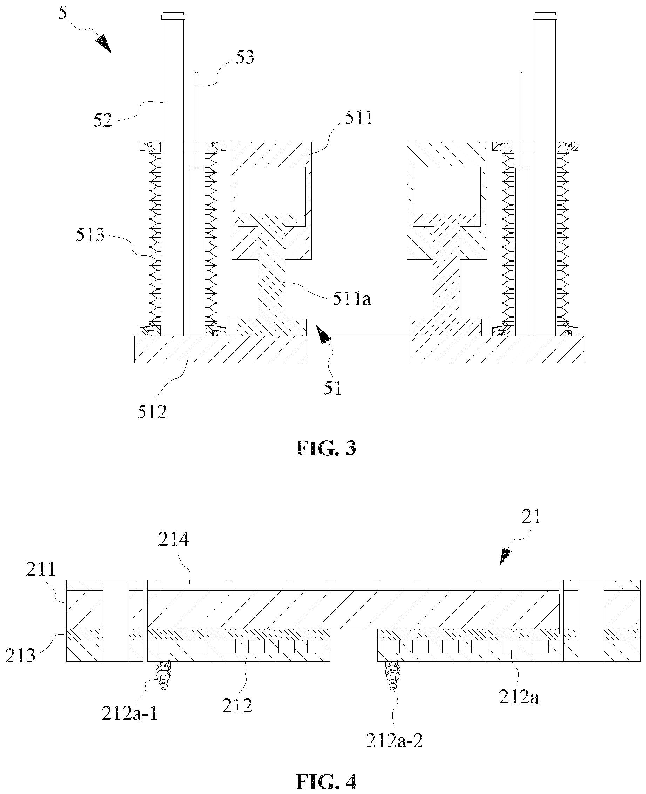

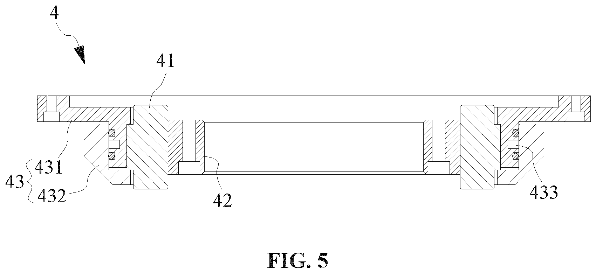

Reference may be made to FIGS. 1 to 5. FIG. 1 is a schematic structural view of a specific embodiment of a wafer stage apparatus provided according to the present application. FIG. 2 is a schematic structural view of a hydromagnetic shaft shown in FIG. 1. FIG. 3 is a schematic structural view of a lifting assembly shown in FIG. 1. FIG. 4 is a schematic structural view of a supporting platform shown in FIG. 1. FIG. 5 is a schematic structural view of a driving assembly shown in FIG. 1.

As shown in FIG. 1, a wafer stage apparatus is provided according to the present application, including a rotating platform assembly 2, a hydromagnetic shaft 3 and a lifting assembly 5. The rotating platform assembly 2 includes a supporting platform 21 and a clamping part 22. The supporting platform 21 is used to support the wafer. The clamping part 22 is used to clamp the wafer to fix the wafer reliably. The clamping part 22 may be an integrated annular structure or may include several split parts distributed in a circumferential direction. The hydromagnetic shaft 3 includes an inner shaft 31 and an outer shaft 32. The inner shaft 31 and the outer shaft 32 may rotate relative to each other. A magnetic fluid 33 is provided between the inner shaft 31 and the outer shaft 32 to realize a sealing between the inner shaft 31 and the outer shaft 32. The inner shaft 31 includes an end member 311 and a cylindrical member 312, which defines an accommodating space 31a. The lifting assembly 5 includes a main body 51 and a lifter 52. The main body 51 is located in the accommodating space 31a. The lifter 52 is slidably and hermetically assembled with the end member 311, and the lifter 52 interacts with the clamping part 22 to control the clamping part 22 to move close to or away from the supporting platform 21. When the clamping part 22 is moved away from the supporting platform 21, the wafer can be conveniently placed or taken out. When the clamping part 22 is moved close to the supporting platform 21, the wafer can be clamped and fixed.

Based on the above solution, the inner shaft 31 of the hydromagnetic shaft 3 may be bucket-shaped, forming therein the accommodation space 31a in which the main body 51 of the lifting assembly 5 for driving the clamping part 22 to move relative to the supporting platform 21 is located. In this way, the internal space of the inner shaft 31 can be more fully utilized, so as to improve the structural compactness and the integration level of the apparatus, effectively reducing the occupied space of the wafer stage apparatus and being convenient for mounting.

Here, the embodiment of the present application is not intended to limit the specific structural form of the lifting assembly 5. In practical application, the skilled in the art can make a choice as required. For example, the lifting assembly 5 may adopt a driving element that can directly output linear displacement, for example, a pneumatic cylinder or a hydraulic cylinder. In this case, the lifter 52 described above may be a piston rod of such a driving element. Alternatively, the lifting assembly 5 may also use a driving element that can directly output rotational displacement, for example, a motor. In this case, it is necessary to provide a displacement conversion mechanism in the form of a rack-and-pinion mechanism, a lead screw mechanism or the like to convert the directly output rotational displacement into the required linear displacement. Taking the rack-and-pinion mechanism as an example, the lifter 52 described above may be a rack.

In the embodiment shown in FIG. 3, the lifting assembly 5 may adopt a standard pneumatic cylinder. The main body 51 may include a pneumatic cylinder 511 and a lifting plate 512. The pneumatic cylinder 511 has a piston rod 511a which is extendable and retractable to drive the lifting plate 512 to move upwards or downwards. The lifter 52 describe above may be mounted on the lifting plate 512. With this structure, the lifting plate 512 is equivalent to a transition connector, on which multiple lifters 52 (two lifters 52 shown in FIG. 3) can be mounted, and then multi-point driving can be realized by a single pneumatic cylinder 511. Thus, on the one hand, the number of the pneumatic cylinders 511 can be reduced to save costs, and the problem of inconsistent actions caused by using multiple pneumatic cylinders 511 can be avoided. On the other hand, the multi-point driving is more conducive to ensuring the stability of raising and lowering of the clamping part 22.

It should be noted that the solution in which a single pneumatic cylinder 511 performs multiple-point driving through the transition connection of the lifting plate 512 is only a preferred solution of the embodiment of present application, but it does not mean that only one pneumatic cylinder 511 can be used in the specific practice. In fact, the number of the pneumatic cylinders 511 may be multiple in order to generate a greater driving force.

Further, the main body 51 may further include a bellows 513. Both ends of the bellows 513 may be connected with the lifting plate 512 and the end member 311, respectively. The bellows 513 may be arranged outside the lifter 52 and configured to achieve sealing assembly of the lifter 52 and the end member 311. Moreover, the bellows 513 has certain elastic deformation ability. When the pneumatic cylinder 511 is inflated to drive the clamping part 22 to move upwards, the bellows 513 may be compressed. When the pneumatic cylinder 511 is deflated, the elastic force of the bellows 513 may be released, which facilitates the quick return of the clamping part 22. Moreover, the bellows 513 may be further configured to limit the stroke of the pneumatic cylinder 511.

It can be understood that the means for achieving the sliding sealing is not limited to the bellows 513, but can also be realized by providing an annular sealing member such as a sealing ring.

The clamping part 22 may clamp and fix the wafer by its own gravity or by the force coming from the lifting assembly 5, which depends on the connection mode between the lifter 52 and the clamping part 22. When the lifter 52 is fixedly connected with the clamping part 22 (means for achieving the connection is not limited), the clamping part 22 may press the wafer under the action of the lifting assembly 5. When the lifter 52 abuts against the clamping part 22, that is, when the lifter 52 can only generate an upward jacking force but cannot generate a downward pulling force, the clamping part 22 may press the wafer under its own gravity. In the embodiment of the present application, the solution in the former is preferably adopted to press and fix the wafer reliably.

The lifting assembly 5 may not only drive the clamping part 22 to move, but also directly drive the wafer to move relative to the supporting platform 21 so as to facilitate the wafer loading and unloading operations. The lifting assembly 5 may further include a jacking pin 53, which is slidably and hermetically assembled to the end member 311 to interact with the wafer.

With reference to FIG. 3, the jacking pin 53 may also be mounted on the lifting plate 512. An axial size of the jacking pin 53 is smaller than that of the lifter 52, so that a supporting height of the lifter 52 is higher than that of the jacking pin 53. When the lifting plate 512 drives the lifter 52 and the jacking pin 53 to lift up, the lifter 52 can drive the clamping part 22 to move away from the supporting platform 21, before the jacking pin 53 becomes in contact with the wafer and drives the wafer to move away from the supporting platform 21. When the lifting plate 512 drives the lifter 52 and the jacking pin 53 to lower down, the lifter 52 can allow the wafer to be stably placed on the supporting platform 21, before the clamping part 22 presses against the wafer. With this arrangement, the interference between the wafer and the clamping part 22 during movement can be well avoided.

For the sealing connection between the jacking pin 53 and the end member 311, reference may be made to the above description about the sealing connection between the lifter 52 and the end member 311. In fact, in the solution shown in FIG. 3, one lifter 52 and one jacking pin 53 may be hermetically assembled by using the same bellows 513. In this way, the number of the bellows 513 can be reduced.

With reference to FIG. 1, the wafer stage apparatus provided according to the application may further include a housing assembly 1 and a driving assembly 4. An internal space of the housing assembly 1 may be communicated with the atmospheric environment. The housing assembly 1 may include a supporting plate 11, and the outer shaft 32 may be mounted on the supporting plate 11 in a sealed manner. The sealing manner is not limited, for example, a sealing ring or gasket may be provided. The accommodating space 31a of the inner shaft 31 may be communicated with the internal space of the housing assembly 1, that is to say, the accommodating space 31a may also be in the atmospheric environment. The driving assembly 4 may be located in the housing assembly 1, and may be in transmission connection with the inner shaft 31, so as to drive the supporting platform 21 via the inner shaft 31 to rotate, achieving the movement required for processing the wafer.

By adopting this solution, the housing assembly 1 may isolate the external vacuum environment (the environment in which the wafer is located when being processed) from the internal atmospheric environment, and the driving assembly 4 may be wholly assembled in the housing assembly 1. In this way, the driving assembly 4 does not need to adopt a special vacuum component, only need to adopt a common component, thus significantly reducing the cost, and improving convenience of assembly and maintenance. The hydromagnetic shaft 3 includes an inner shaft 31 and an outer shaft 32 sealed by the magnetic fluid 33. The outer shaft 32 is hermetically assembled with the supporting plate 11, which may achieve isolation of the accommodating space 31a from the external vacuum environment. The accommodating space 31a is in communication with the atmospheric environment, causing the accommodating space 31a to be in the atmospheric environment. As such, none of the components (e.g., the main body 51 described above) assembled in the accommodating space 31a needs to use the special vacuum component, but only the common component is used, thus further reducing the cost, and improving convenience of assembly and maintenance.

Here, the embodiment of the present application is not intended to limit the specific structural form of the housing assembly 1, as long as it can achieve the technical effect of accommodating the driving assembly 4.

With reference to FIG. 1, the housing assembly 1 is further connected with a revolving shaft 8, and the revolving shaft 8 is also connected with a driving element (not shown). Under the action of the driving element, the housing assembly 1, together with the hydromagnetic shaft 3, the rotating platform assembly 2 and the like, may rotate integrally to adjust an angle of the supporting platform 21. The driving assembly 4 is configured to realize the rotation of the supporting platform 21. The revolving shaft 8 may be a hollow cylindrical member for communicating the internal space of the housing assembly 1 with the external environment.

The driving assembly 4 may adopt a motor, including a stator 41, a rotor 42 and a mounting member 43. The rotor 42 may be in transmission connection with the inner shaft 31. The mounting member 43 is used for mounting the driving assembly 4, and a second cooling channel 433 is arranged in the mounting member 43 to cool and control the temperature of the motor so as to ensure the working performance of the motor.

The connection between the rotor 42 and the inner shaft 31 may be varied as long as the reliability of power transmission can be ensured. For example, pulleys, sprockets, gears or the like can be used for transmission connection, so as to adjust the transmission ratio. In the embodiment as shown in FIGS. 1, 2 and 5, the rotor 42 may be connected to the inner shaft 31 via the rotating plate 35 so as to adapt to the mounting positions of the rotor 42 and the inner shaft 31. It can be understood that the rotor 42 may also be directly connected to the inner shaft 31 if the mounting position permits.

Similarly, the structural forms of the mounting member 43 may be varied as long as the mounting reliability of the mounting member 43 can be ensured. In the embodiment as shown in FIG. 5, the mounting member 43 may include a first connecting portion 431 and a second connecting portion 432. The first connecting portion 431 may be connected with the outer shaft 32, and the second connecting portion 432 may be connected with the first connecting portion 431. The connection manner may include but not be limited to threaded connection, screw connection, interference fit, snap-fit, welding, etc. The second cooling channel 433 may be formed between the first connecting portion 431 and the second connecting portion 432. The second cooling channel 433 may be formed by arranging a groove on one or both of the surfaces of the first connecting portion 431 and the second connecting portion 432 facing each other. A sealing member such as a sealing ring or a gland packing may be provided at each of the axial sides of the second cooling channel 433 to ensure sealing performance.

In this way, the driving assembly 4 is integrated and assembled to the outer shaft 32, which in turn is assembled to the supporting plate 11. That is, the whole apparatus is integrated and assembled to the supporting plate 11, achieving a compact structure and a reduced size. Moreover, the arrangement of the second cooling channel 433 may improve the cooling performance of the motor, and the working temperature of the motor may be controlled under long-term working conditions, so as to ensure the working stability and efficiency of the motor.

In fact, the mounting member 43 is not limited to being connected to the outer shaft 32, but may be directly fixed to the supporting plate 11, in which case the mounting and fixing of the driving assembly 4 can also be realized.

In addition, the type of the cooling medium introduced into the second cooling channel 433 is not limited here. In practice, those skilled in the art may make choice based on actual needs, as long as it can meet the use requirements. For example, the cooling medium may be a gaseous cooling medium, such as cooling air. Alternatively, the cooling medium may be a liquid cooling medium, e.g., cooling water.

Further, the first connecting portion 431 may be provided with a first stop, and the second connecting portion 432 may be provided with a second stop. The stator 41 may be fixedly assembled in the axial direction by the first stop and the second stop.

As mentioned in the background, the common wafer processing technologies include ion beam etching and ion beam deposition, which have different requirements for ambient temperature. Generally, a cooling environment is required during the ion beam etching, while a thermal environment is required during the ion beam deposition.

Based on this, the supporting platform 21 provided according to the embodiment of the present application may include a heating platform portion 211 and a cooling platform portion 212. The heating platform portion 211 may be used for heating to provide a hot environment for the ion beam deposition, and the cooling platform portion 212 may be used for cooling to provide a cold environment for the ion beam etching. Thus, that wafer stage apparatus provided according to the embodiment of the present application can be compatible with two wafer processing processes of ion beam etching and ion beam deposition.

Here, the heating mode of the heating platform portion 211 and the cooling mode of the cooling platform portion 212 are not limited in the embodiment of the present application, as long as the corresponding functions can be satisfied.

The heating platform portion 211 may provide heat by electric heating, for example, may be provided with an embedded heating wire. The cooling platform portion 212 may provide cooling by convection heat exchange. In this embodiment, referring to FIG. 4, a side of the cooling platform portion 212 facing the heating platform portion 211 may be provided with a third cooling channel 212a. The supporting platform 21 may further include a sealing portion 213, which may be arranged between the cooling platform portion 212 and the heating platform portion 211 to ensure the sealing performance of the third cooling channel 212a. The cooling platform portion 212 may be provided with an inlet 212a-1 and an outlet 212a-2 which are communicated with the third cooling channel 212a, so as to realize the circulation of the cooling medium. The type of cooling medium may include the gaseous cooling medium and the liquid cooling medium.

In some alternative embodiments, the supporting platform 21 may further include a back helium portion 214, which may be located on the side of the heating platform portion 211 facing away from the cooling platform portion 212, that is, close to the wafer, to timely introduce helium gas during wafer processing so as to meet the requirements of wafer processing.

As mentioned above, when the ion beam deposition is carried out, a relatively high ambient temperature is required, which is usually higher than 120°C. However, the service temperature of the hydromagnetic shaft 3 is only between - 40°C and 120°C. When the temperature exceeds 120°C, the sealing performance of the magnetic fluid 33 will be affected, and the bearing 34 of the hydromagnetic shaft 3 will be overheated, affecting the service life and service state of the bearing 34, and thus causing the unstable rotation of the hydromagnetic shaft 3 and seriously affecting the normal use of the hydromagnetic shaft 3.

For this reason, in the embodiment of the present application, the end member 311 may be provided with a first cooling channel 311a for controlling the temperature of the hydromagnetic shaft 3. The first cooling channel 311 a may be formed by arranging a groove on a side of the end member 311 facing the supporting platform 21. Then, the groove may be covered by the sealing plate 313 (the fixing methods of the sealing plate 313 include but are not limited to welding, screw connection, riveting, etc.) and thus be sealed.

It should be noted that the first cooling channel 311a is not limited to be arranged on the end member 311, but may be arranged in the cylindrical member 312 or in the outer shaft 32, which may be a possible solution in practice.

Further, the wafer stage apparatus provided according to the present application may further include a rotating joint 6 and a transition plate 7. Both of the rotating joint 6 and the transition plate 7 may be locate inside the cylindrical member 312, that is, both of the them may be located in the aforementioned accommodating space 31a, so as to fully utilize the internal space of the inner shaft 31. The rotating joint 6 may be connected to the end member 311 via the transition plate 7. With this structure, the mounting position of the rotating joint 6 may be adjusted by the arrangement of the transition plate 7. Moreover, it can also solve the problem of interface mismatch when the rotating joint 6 is directly connected with the end member 311, that is, the both axial ends of the transition plate 7 may have two forms of interfaces respectively, one of which is used for connecting with the end member 311 and the other of which is sued for connecting with the rotating joint 6.

It can be understood that the transition plate 7 may be omitted in practice. In this case, the rotating joint 6 may be directly connected with the end member 311, which does not affect the rotating joint 6 to transmit the rotary driving force to the inner shaft 31.

The rotating joint 6 is a joint integrated with gas, electricity and liquid connections, and a helium pipeline, a coolant pipeline, a conductive wire, a signal wire and the like may pass through the rotating joint 6.

The above descriptions are merely preferred embodiments of the present application. It should be noted that various improvements and modifications can be made by those skilled in the art without departing from the principles of the present application. These improvements and modifications should fall within the protection scope of the present application.

## Claims

1. A wafer stage apparatus, comprising:
a rotating platform assembly (2) which comprises a supporting platform (21) configured to support a wafer and a clamping part (22) configured to clamp the wafer;
a hydromagnetic shaft (3) which comprises an inner shaft (31) and an outer shaft (32), wherein a magnetic fluid (33) is provided between the inner shaft (31) and the outer shaft (32), and the inner shaft (31) comprises an end member (311) and a cylindrical member (312) which define an accommodating space (31a); and
a lifting assembly (5) which comprises a main body (51) and a lifter (52), wherein the main body (51) is located in the accommodating space (31a), the lifter (52) is slidably and hermetically assembled to the end member (311), and the lifter (52) interacts with the clamping part (22).

2. The wafer stage apparatus according to claim 1, wherein the main body (51) comprises a pneumatic cylinder (511) and a lifting plate (512), wherein the pneumatic cylinder (511) is provided with a piston rod (511a) which is connected with the lifting plate (512), and the lifting plate (512) is connected with a plurality of the lifter (52).

3. The wafer stage apparatus according to claim 2, wherein the main body (51) further comprises a bellows (513), two ends of the bellows (513) are respectively connected with the lifting plate (512) and the end member (311), and the bellows (513) is mounted outside the lifter (52).

4. The wafer stage apparatus according to claim 1, wherein the lifting assembly (5) further comprises a jacking pin (53), and the jacking pin (53) is slidably and hermetically assembled to the end member (311).

5. The wafer stage apparatus according to claim 4, wherein one lifter (52) and one jacking pin (53) share one bellows (513) for sealing assembly.

6. The wafer stage apparatus according to claim 4, wherein the main body (51) comprises a pneumatic cylinder (511) and a lifting plate (512), the pneumatic cylinder (511) is provided with a piston rod (511a) which is connected with the lifting plate (512), the jacking pin (53) and the lifter (52) are both mounted on the lifting plate (512), and an axial size of the jacking pin (53) is smaller than that of the lifter (52).

7. The wafer stage apparatus according to claim 1, wherein the hydromagnetic shaft (3) is provided with a first cooling channel (311a).

8. The wafer stage apparatus according to claim 7, wherein a side of the end member (311) facing the supporting body (21) is provided with a groove, a sealing plate (313) is provided on the side of the end member (311) facing the supporting body (21) and covers an opening of the groove, and the first cooling channel (311a) comprises an internal space of the groove.

9. The wafer stage apparatus according to any one of claims 1 to 8, further comprising:
a housing assembly (1), wherein an internal space of the housing assembly (1) is communicated with atmospheric environment, the housing assembly (1) comprises a supporting plate (11), and the outer shaft (32) is hermetically assembled on the supporting plate (11); and
a driving assembly (4), wherein at least part of the driving assembly (4) is located in the housing assembly (1), and the driving assembly (4) is in transmission connection with the inner shaft (31).

10. The wafer stage apparatus according to claim 9, wherein the driving assembly (4) comprises a stator (41), a rotor (42) and a mounting member (43), wherein the rotor (42) is in transmission connection with the inner shaft (31), and the mounting member (43) is configured for mounting the driving assembly (4).

11. The wafer stage apparatus according to claim 10, wherein the mounting member (43) is provided with a second cooling channel (433).

12. The wafer stage apparatus according to claim 11, wherein the mounting member (43) comprises a first connecting portion (431) and a second connecting portion (432) which are connected with each other, the first connecting portion (431) is connected with the outer shaft (32), and the second cooling channel (433) is formed between the first connecting portion (431) and the second connecting portion (432).

13. The wafer stage apparatus according to claim 12, wherein the first connecting portion (431) is provided with a first stop, the second connecting portion (432) is provided with a second stop, and the stator (41) is positioned and assembled by the first stop and the second stop.

14. The wafer stage apparatus according to claim 10, further comprising a rotating plate (35), wherein the rotor (42) is connected to the inner shaft (31) via the rotating plate (35).

15. The wafer stage apparatus according to claim 9, further comprising a revolving shaft (8), wherein the revolving shaft (8) is connected with the housing assembly (1).

16. The wafer stage apparatus according to any one of claims 1 to 8, wherein the supporting platform (21) comprises a heating platform portion (211) and a cooling platform portion (212).

17. The wafer stage apparatus according to claim 16, wherein a surface of the cooling platform portion (212) facing the heating platform portion (211) is provided with a third cooling channel (212a); and
the wafer stage apparatus further comprises a sealing portion (213) which is arranged between the cooling platform portion (212) and the heating platform portion (211).

18. The wafer stage apparatus according to claim 16, further comprising a back helium portion (214), wherein the back helium portion (214) is located on a side of the supporting platform (21) close to the wafer.

19. The wafer stage apparatus according to any one of claims 1 to 8, further comprising a rotating joint (6) which is connected with the end member (311).

20. The wafer stage apparatus according to claim 19, further comprising a transition plate (7), wherein the rotating joint (6) is connected to the end member (311) via the transition plate (7).
